Europäisches Patentamt

European Patent Office

Office européen des brevets

(11) Publication number: **0 359 413**
**A2**

## EUROPEAN PATENT APPLICATION

(21) Application number: 89308418.6

(51) Int. Cl.5: **H01L 23/538 , H01L 25/16**

(22) Date of filing: **18.08.89**

A request for addition of claim 10 has been filed pursuant to Rule 88 EPC. A decision on the request will be taken during the proceedings before the Examining Division (Guidelines for Examination in the EPO, A-V, 2.2).

(30) Priority: **16.09.88 GB 8821829**

(43) Date of publication of application:
**21.03.90 Bulletin 90/12**

(84) Designated Contracting States:
**DE FR IT SE**

(71) Applicant: **STC PLC**
**10, Maltravers Street**
**London, WC2R 3HA(GB)**

(72) Inventor: **McDougall, Andrew Murry**
**16, Kalmia Green Gorleston**
**Great Yarmouth Norfolk(GB)**
Inventor: **Winster, Anthony Eric**
**8, Lynn Grove Gorleston**
**Great Yarmouth Norfolk(GB)**

(74) Representative: **Dupuy, Susan Mary et al**
**STC Patents West Road**
**Harlow Essex CM20 2SH(GB)**

(54) **Hybrid circuits.**

(57) A co-fired hybrid circuit includes silver internal connections, such as vias (1,4) and patterns (3), and gold-based external connections (6). A diffusion barrier (9′), for example of palladium-silver, covers a via (4) which extends towards an external surface of an outermost layer (5) of a stack of ceramic sheets (2, 5). The diffusion barrier (9′) can be screen printed onto layer (5) following formation of the via (4) and prior to lamination, burn out and firing of the stack. The gold external connections are applied subsequently to firing.

EP 0 359 413 A2

*Fig.5.*

## HYBRID CIRCUITS

This invention related to hybrid circuits and in particular to co-fired hybrid circuits and interconnection systems and methods of manufacturing them for use in co-fired hybrid circuits.

A hybrid circuit is a circuit arrangement consisting of a number of insulating layers in a multilayer structure. The layers carry conductive circuit patterns and conductive via connections can be provided between different layers through the layers. A recess can be provided in a co-fired structure and one or more semiconductor devices can be mounted in the recess and electrically connected by wires to appropriate conductors of the structure, for example, those which are exposed at the recess. Hybrid structures have conventionally been manufactured by thick film techniques, in which each additional layer is built up and fired in sequence, but these are impracticable for recess manufacture due to the recess depth required. The necessary processing is lengthy as well as costly and the yield is poor.

Low-temperature co-firing ceramics are now available in a flexible tape form . These materials fire at 850° C and therefore gold or silver can be used for the internal conductive patterns and vias. It is possible to use silver, rather than the less mobile gold, since the resultant structure is hermetic. The previously available co-firing ceramics fire at temperatures of the order of 1400° C and thus require high temperature resistant conductor systems such as of tungsten, but this is disadvantageous due to its high resistance. By co-firing is meant that a multilayer structure is built up and then fired, rather than having to fire each applied layer in sequence as with thick film processing.

The basic method of making hybrid circuits using the low temperature co-firing ceramics comprises building up a multilayer structure from sheets cut out of a flexible tape of the ceramic material, after having formed conductive patterns and vias with the use of appropriate conductive inks, bonding the sheets together in a lamination process into a unitary structure and subsequently burning out, to remove organic constituents, and firing it. The vias are formed by cutting holes through the sheets where required and filling them with a suitable conductive ink. The conductive patterns are formed by appropriate screen printing on the uppermost surface of the sheets requiring them. The sheets all have registration holes punched in their corners for alignment purposes. To maintain alignment, a lamination jig includes alignment pins corresponding to the registration holes.

The present invention is concerned with the electrical interconnections and in particular the external electrical contacts to the hybrid circuit.

According to one aspect of the present invention there is provided a co-fired hybrid circuit characterised by silver internal connections, gold based external connections and a diffusion barrier between the internal and external connections.

According to another aspect of the present invention there is provided a method of manufacturing a co-fired hybrid circuit having silver interconnections and gold based external connections, characterised by the steps of assembling a stack of co-firing ceramic layers upon some of which silver interconnection patterns are provided and in some of which silver via interconnections are provided, there being at least one such silver via extending towards an external surface of the stack; providing a diffusion barrier layer over said via at said external surface; laminating, burning out and firing said stack; and providing a said gold based external connection to cover said diffusion layer.

Embodiments of the invention will now be described with reference to the accompanying drawings in which:

Figure 1 illustrates a cross-section through part of a substrate with an interconnection scheme;

Figure 2 illustrates the scheme of Figure 1 following firing;

Figure 3 illustrates another scheme after firing;

Figure 4 illustrates an alternative scheme, and

Figure 5 illustrates an interconnection scheme according to the present invention.

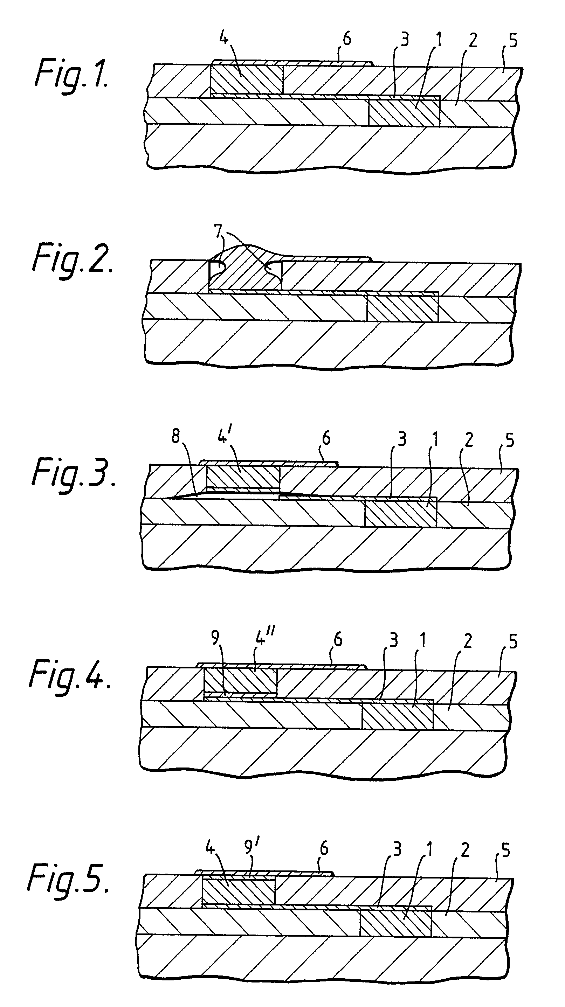

The external electrical contacts to hybrid circuits are conventionally of gold or are gold based. In the case of silver internal connections and vias, as are possible with low temperature co-firing ceramics, we have found that gold or gold based external contacts advantageously do not interface directly with an internal pure silver interconnect system. Figure 1 illustrates a section through an upper part of a multilayer structure (hybrid circuit) prior to firing. Reference numeral 1 indicates a via through one ceramic layer 2, reference numeral 3 indicates part of an electrically conductive pattern on layer 2, reference numeral 4 indicates a via through outer ceramic layer 5 and reference numeral 6 indicates an external contact. Parts 1,3,4 and 6 are electrically connected as shown. The vias 1 and 4 and pattern part 3 are of silver and the external contact 6 of gold. Thus the system comprises a silver interconnect system interfacing with a gold wire bond pattern at the top surface of the via 4 through the top ceramic layer.

2

After burning out and firing, the gold wire bond pattern over the silver via 4 had a raised or domed shape as illustrated in Figure 2, and was silver in colour. The domed appearance was believed to be caused by a local increase in the volume of gold at the gold silver interface where the silver had diffused into the gold, leaving voids 7 in the via. The substrate was refired during subsequent processing and the voiding increased until the gold and silver no longer joined and an open circuit was formed. Similar voiding was found to occur at a lower part of the multilayer structure at an interface between silver vias and overlying platinum gold solder pads (not shown).

An available, alternative, via fill material is of palladium silver, with a silver palladium ratio of 8:1, i.e. 11% palladium. The purpose of the introduction of the palladium into the silver was to guard against silver migration and solder leaching. In the belief that the palladium may also reduce the amount of interdiffusion between the silver and the gold we substituted the silver via material 4 with palladium silver so that there was an interface between a palladium silver via and the gold wire bond pattern. We also substituted the silver via material with palladium silver via material where the former interfaces with platinum gold solder pads.

After burning out and firing the substrates in the usual manner, cracks were evident in the ceramic material between the vias. The lamination, burnout and firing processes were suspected as causing the cracks but no variation in process parameters removed the fault. The palladium silver via fill material was therefore suspected to have a different coefficient of thermal expansion and/or shrinkage rate to the tape ceramic.

Although no solution to the cracking was available further packages with the palladium silver vias were built and the gold wire bond pattern screened and fired. A continuity test found several open circuits. Following refiring several times the continuity test was repeated. The number of open circuits increased with the number of firings in a similar manner to that obtained with the silver vias. A high voltage test was carried out to determine where the open circuits were. A variable voltage was applied across the wire bond site and the corresponding solder pad of a known open circuit interconnect. As the applied voltage was increased from zero to approximately 800 volts an arc could be seen at the via. The fault was thus narrowed down to the interface between the gold and palladium silver via, or between the silver interconnect 3 and the palladium silver via. The gold wire bond pattern was ground off to expose the underlying palladium silver via. The substrate was retested for continuity and still showed open circuits. Thus the fault lay between the palladium silver via and the silver interconnect.

Suspect portions of the substrate were sectioned to examine the interface between the silver interconnect 3 and the palladium silver via 4' (Figure 3). A large amount of cracking and delamination 8 was evident between the layers 2 and 5 adjacent to the palladium silver via 4'. The interface between the palladium silver via 4' and the gold wire bond pattern 6 showed very little voiding even after repeated firing. The evidence of the cross-sections together with the fact that the number of open circuits increased with the number of firings supported the speculation that there was a mismatch in the coefficients of thermal expansion between the palladium silver via fill material and the ceramic tape.

Thus the use of palladium silver via fill material was ruled out as a solution to the voiding observed between the silver vias and the gold wire bond pattern. However, as the interface between the palladium silver and the gold wire bond pattern exhibited little of the voiding previously observed, it was decided to introduce a palladium silver diffusion barrier into the material system.

To minimise the possibility of silver migration across the top surface of the substrate and to remove the gold/silver interdiffused region from the wirebond sites the material system illustrated in Figure 4 was employed. Via 1 and interconnection 3 are silver as before. Via 4" is of gold and there is a palladium silver diffusion barrier 9. The latter was screen printed over the interconnect pattern on tape layer 2 using the via fill screen from the tape layer 5. The substrates were laminated, burned out and fired in the usual manner and a continuity test carried out. A large number of open circuits were observed. Suspect substrate portions were sectioned and a large amount of voiding was evident between the gold vias 4" and the underlying silver, especially where gold vias were stacked over silver vias. This material system gave rise to the most prominent case of voiding experienced and suggested that the amount of voiding was proportional to the volume of gold available to accept silver during interdiffusion, the gold in the via being approximately ten times thicker than the wire bond gold. This introducing a palladium silver diffusion barrier below a gold barrier clearly did not work.

A diffusion barrier 9' was then provided on the top of a silver via 4 (Figure 5) instead, forming a cap or plug to the via. The palladium silver diffusion barrier 9' is screen printed onto via 4 in the layer 5 using the via fill screen employed for the tape layer 5. A similar system (not shown) was employed between the silver vias and platinum gold solder pads. The palladium silver was 14% palladium and of the order of 1 thou. thick, whereas the vias were of a thickness dependent on the ceramic thickness, i.e. 4 or 12 thou. in the unfired state.

The substrate was laminated, burned out and fired in the usual manner. A continuity test was carried out to ensure that the basic structure was electrically good and then the wire bond pattern and solder pad patterns were screened and fired. No open circuits were evident in a subsequent continuity test. Sections of the substrate were made and very little void formation was evident.

To evaluate the effect of gold thicknesses on void formation and the addition of palladium silver diffusion barriers an experiment was performed. This measured the number of open circuits obtained after successive firings for various test groups. The results are quoted in Table 1.

TABLE I.

| No. of firings | Groups | | | | | |
|---|---|---|---|---|---|---|
| | 1 | 2 | 3 | 4 | 5 | 6 |
| 1 | 0 | 0 | 0 | 0 | 12 | 0 |
| 2 | 0 | 0 | 2 | 0 | 20 | 0 |
| 3 | 0 | 0 | 4 | 0 | 28 | 0 |
| 4 | 0 | 0 | 5 | 0 | 28 | 0 |
| 5 | - | - | - | - | 30 | 0 |
| 6 | 0 | 0 | 8 | 0 | 24 | 0 |
| 7 | - | - | - | - | 23 | 0 |
| 8 | 0 | 0 | 15 | 5 | - | - |
| 9 | - | - | - | - | - | - |
| 10 | 0 | 0 | 28 | 9 | - | - |

Group 1 0.00045" Gold over silver via

Group 2 0.00045" Gold over palladium silver capped silver via

Group 3 0.0009" Gold over silver via

Group 4 0.0009" Gold over palladium silver capped silver via

Group 5 0.0009" Platinum Gold over silver via

Group 6 0.0009" Platinum Gold over palladium silver capped silver via

Groups 1, 2, 3 and 4 had 1080 probe points

Groups 5 and 6 had 820 probe points

Gold - Dupont 5710

Silver - Dupont 6141

Palladium silver - Dupont 6144

Platinum gold - Dupont 4596

From the table it is clear that increase in thickness of wire bond gold pattern greatly increases the occurence of open circuits. Groups 1 and 2 showed no open circuits after ten firings. Group 3 showed the worst effect of void formation of groups 1 to 4, whereas the formation of voids was retarded until eight firings by the introduction of the palladium silver diffusion barrier as in group 4. Groups 5 and 6 were representative of 0.0009" thick platinum gold solder pads which have to be screened thick due to the effects of solder leaching during later component assembly processes. Group 5 suffered badly from void formation leading to open circuits but the inclusion of the palladium silver diffusion barrier retarded the formation of voids and no open circuits were observed after seven firings.

Thus the volume of gold available to accept silver during interdiffusion appears to be the most important factor in the formation of voids during the initial and subsequent firing operations. Where it is not possible to use thin gold, such as on solder pads, a palladium silver diffusion barrier between the silver via

4

and the gold is particularly advantageous and even where it is possible to use thin gold such a palladium silver diffusion barrier is also advantageous.

Whereas a palladium silver diffusion barrier comprising a layer disposed on the outermost face of the silver via in the form of a plug for the via as illustrated in Figure 5 has proved most effective it is considered that similar plug-like diffusion barriers of alternative materials may be equally effective. Diffusion barriers per se are known and many different materials have been used for the purpose, including nickel, copper, chromium.

## Claims

1. A co-fired hybrid circuit characterised by silver internal connections (1, 4, 3), gold based external connections (6) and a diffusion barrier (9´) between the internal and external connections.

2. A co-fired hybrid circuit as claimed in claim 1 characterised in that the diffusion barrier (9´) is of palladium silver.

3. A co-fired hybrid circuit as claimed in claim 1 or claim 2 characterised in that a silver via (4) of the internal connections extends towards at an external surface of a co-fired stack of ceramic layers (2, 5) and wherein the diffusion barrier (9´) comprises a layer covering the silver via (4) at said external surface.

4. A co-fired hybrid circuit as claimed in claim 3 characterised by a gold wire bond pattern (6) disposed on said external surface and covering the diffusion barrier (9´).

5. A co-fired hybrid circuit as claimed in claim 3 characterised by a platinum-gold solder pad, comprising said gold based external connections, disposed on said external surface and covering the diffusion barrier.

6. A co-fired hybrid circuit as claimed in claim 3 characterised in that the via is of the order of 4 to 12 thou. thick and the diffusion barrier is of the order of 1 thou. thick.

7. A method of manufacturing a co-fired hybrid circuit having silver interconnections and gold based external connections characterised by the steps of assembling a stack of co-firing ceramic layers (2, 5) upon some of which silver interconnection patterns (3) are provided and in some of which silver via interconnections (1, 4) are provided, there being at least one such silver via (4) extending towards an external surface of the stack; providing a diffusion barrier layer (9´) over said via at said external surface; laminating, burning out and firing said stack; and providing a said gold based external connection (6) to cover said diffusion layer (9´).

8. A method as claimed in claim 7 characterised in that the diffusion barrier (9´) is of the palladium silver.

9. A method as claimed in claim 7 or claim 8 characterised in that the stack is fired at a temperature of the order of 850˚C.

11. A co-fired hybrid circuit manufactured by a method according to any one of the claims 7 to 10.

Fig.1.

Fig.2.

Fig.3.

Fig.4.

Fig.5.